# EUROPÄISCHE PATENTSCHRIFT

(11) **EP 1 029 104 B1**
(45) Veröffentlichungstag und Bekanntmachung des Hinweises auf die Patenterteilung: **19.09.2001**
(21) Anmeldenummer: 98961040.7
(22) Anmeldetag: 21.10.1998
(51) Int. Cl.: C23C 14/06, C23C 14/22

(54) **GASSTRAHL-PVD-VERFAHREN ZUR HERSTELLUNG EINER SCHICHT MIT MoSi2**
GAZ JET PVD METHOD FOR PRODUCING A LAYER WITH MoSi2
PROCEDE DE DEPOT PHYSIQUE EN PHASE VAPEUR AVEC JET DE GAZ POUR LA REALISATION D'UNE COUCHE AVEC DU MoSi2

(30) Priorität: 03.11.1997 DE 19748541
(43) Veröffentlichungstag der Anmeldung: 23.08.2000
(73) Patentinhaber: SIEMENS AKTIENGESELLSCHAFT, 80333 München (DE)
(72) Erfinder: BEELE, Wolfram, D-40883 Ratingen (DE)
(86) Internationale Anmeldenummer: DE9803124
(87) Internationale Veröffentlichungsnummer: WO9923274

(56) Entgegenhaltungen:
- WO-A-96/31636
- US-A- 4 128 466
- HALPERN B L ET AL: "JET VAPOR DEPOSITION OF SINGLE AND MULTICOMPONENT THIN FILMS" METAL FINISHING, Bd. 90, Nr. 12, 1. Dezember 1992, Seiten 37-41, XP000335421

## Beschreibung

Die Erfindung betrifft ein Verfahren zur industriellen Herstellung einer Schicht mit MoSi₂, insbesondere für einen Erosionsschutz einer Gasturbinenschaufel.

Aus der US-PS 3,684,557 geht ein Verfahren zur Vakuumverdampfung hochschmelzender nichtmetallischer Materialien hervor. Mit einer Elektronenstrahlverdampfung werden solche Materialien, insbesondere Siliziumdioxid, verdampft. Zur Vermeidung eines Einbrennens von Nuten in das zu verdampfende Material durch den Elektronenstrahl wird dieser in geeigneter Weise über das Material geführt und dabei in seiner Intensität geregelt.

In der WO 96/31636 ist eine Gasturbinenschaufel beschrieben, die eine keramische Wärmedämmschicht aufweist. Zum Schutz vor einer Erosion der Wärmedämmschicht ist auf diese eine Silizidschutzschicht aufgebracht, insbesondere eine MoSi₂-Schutzschicht.

Aufgabe der Erfindung ist die Angabe eines Verfahren zur industriellen Herstellung einer Schicht mit MoSi₂.

Erfindungsgemaß wird diese Aufgabe gelöst durch ein Verfahren zur industriellen Herstellung einer Schicht mit MoSi₂ auf einem Substrat mittels eines Gasstrahl-PVD-Verfahrens, bei dem Ionen eines Sputtergases in Richtung auf mindestens ein Target beschleunigt werden, welche Ionen Molybdän und Silizium aus dem mindestens einen Target herausschlagen und zum Substrat transportieren, wobei sich das herausgeschlagene Molybdän und Silizium auf das Substrat absetzen.

Die industrielle Herstellung von Schichten erfordert eine hohe Beschichtungsrate. Eine solche hohe Beschichtungsrate kann über eine Elektronenstrahlverdampfung des Beschichtungsmateriales erreicht werden. Versuche haben allerdings zu der der Erfindung zugrundeliegenden Erkenntnis geführt, daß für die Herstellung von Schichten mit Molybdändisilicid (MoSi₂) eine Elektronenstrahlverdampfung ungeeignet ist. Dies liegt in erster Linie daran, daß es durch die unterschiedlichen Dampfdrücke von Molybdän und Silizium zu einer erheblichen Materialentmischung kommt, so daß das für die Bildung von Molybdänsilicid nötige Verhältnis von Molybdän zu Silizium nicht einstellbar ist. Indem ein Gasstrahl-PVD-Verfahren verwendet wird, ist es hingegen möglich, eine Schicht mit MoSi₂ herzustellen. Zudem ist man mit dem Gasstrahl-PVD-Verfahren in der Lage, solche Molybdänsilicidschichten auch in einem industriellen Umfang, d.h. mit hohen Beschichtungsraten, herzustellen.

Vorzugsweise wird eine Beschichtungsrate zwischen 10 und 100 µm/h, insbesondere zwischen 30 und 80 µm/h eingestellt.

Bevorzugt ist das Substrat auf einer Gasturbinenschaufel aufgebracht und zwar insbesondere als keramische Wärmedämmschicht. Eine Gasturbinenschaufel ist in der Regel mit einer Oxidations- bzw. Korrosionsschutzschicht versehen, um den hohen oxidativen und korrosiven Angriffen beim Einsatz der Gasturbinenschaufel begegnen zu können. Zudem ist häufig auf die Schutzschicht eine keramische Wärmedämmschicht aufgebracht, die die Gasturbinenschaufel vor zu hohen Temperaturen schützt. Eine solche Wärmedämmschicht unterliegt der Erosion durch Teilchen, welche in dem Heißgas mitgeführt werden, das die Gasturbinenschaufel umströmt. Ein Erosionsschutz wird dadurch erreicht, daß die Wärmedämmschicht mit einem duktilen Material beschichtet wird. In einem solchen duktilen Material bleiben die erodierenden Teilchen stecken, ohne die darunterliegende Wärmedämmschicht zu beschädigen. Insbesondere Molybdänsilicid bietet gute mechanische Eigenschaften als Erosionsschutz. Um Gasturbinenschaufeln kostengünstig herstellen zu können, muß die Silicidschicht in einer angemessen kurzen Zeit, d.h. mit einer hohen Beschichtungsrate aufgebracht werden. Somit erweist sich das Gasstrahl-PVD-Verfahren als besonders geeignet, zur Beschichtung von Gasturbinenschaufeln mit einer Molybdänsilicidschicht.

Vorzugsweise ist die Schicht aus MoSi₂ und Silizium aufgebaut. Weiter bevorzugt wird die Schicht unter Anwesenheit von Sauerstoff gebildet. Mit MoSi₂ ist Molybdändisilicid gemeint. Indem die Molybdänsilicidschicht aus den genannten Bestandteilen aufgebaut wird, ergibt sich eine besonders hohe Rißbeständigkeit für diese Schicht. Dies ist darauf zurückzuführen, daß das freie Silizium zu Siliziumdioxid (SiO₂) oxidiert. Es bilden sich somit Siliziumdioxid-Nester, welche eine Rißausbreitung vermindern.

Bevorzugtermaßen wird ein erstes Target aus Molybdän und ein zweites Target aus Silizium verwendet, wobei die Ionen zum ersten und zum zweiten Target unter einer jeweils anderen, den unterschiedlichen spezifischen Widerständen von Molybdän und Silizium angepaßten Spannungen beschleunigt werden. Indem ein Target aus Molybdän und ein zweites Target aus Silizium verwendet werden, kann das gewünschte Verhältnis von Molybdän zu Silizium für die Beschichtung in einfacher Weise über die jeweils den auftreffenden Ionen ausgesetzten Flächen der Targets eingestellt werden. Dabei kann der unterschiedliche spezifische Widerstand von Molybdän und Silizium dadurch berücksichtigt werden, daß an dem jeweiligen Target eine an den jeweiligen spezifischen Widerstand von Molybdän bzw. Silizium angepaßte Spannung anliegt. Bevorzugt werden das erste und das zweite Target einander gegenüberliegend angeordnet. Weiter bevorzugt können die Targets ineinander geschachtelt sein, z.B. können in einem Molybdän-Target Stücke von Silizium eingebaut sein.

Bevorzugtermaßen besteht das Target aus, insbesondere vorgesintertem, MoSi₂/Si, wobei ein spezifischer Widerstand kleiner als 700 Ωm eingestellt wird.

Bevorzugtermaßen werden die Ionen aus einem Gleichstrom-Glimmentladungsplasma beschleunigt. Ein solches Gleichstrom-Glimmentladungsplasma hat gegenüber einem alternativen Hochfrequenz-Glimmentladungsplasma den Vorteil, kostengünstiger und einfacher in der Handhabung zu sein, wobei gleichzeitig ein höherer Wirkungsgrad erreicht wird.

Die Erfindung wird in einem Ausführungsbeispiel anhand der Zeichnung näher erläutert. Es zeigen:
- FIG 1: eine schematische Darstellung eines Gasstrahl-PVD-Verfahrens und
- FIG 2: einen Ausschnitt eines Längsschnittes durch eine Gasturbinenschaufel mit einer Beschichtung.

Gleiche Bezugszeichen haben in den verschiedenen Figuren die gleiche Bedeutung.

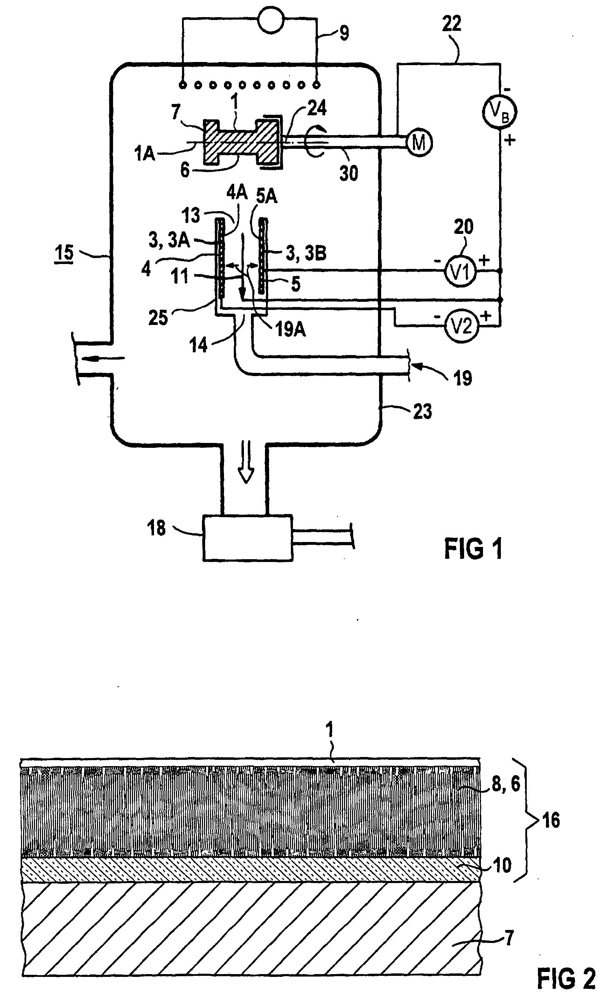

In Figur 1 ist schematisch und nicht maßstäblich ein prinzipieller Aufbau einer Beschichtungsvorrichtung 15 zur Durchführung eines Gasstrahl-PVD-Verfahrens dargestellt. Die Beschichtungsvorrichtung 15 weist ein Gehäuse 23 auf, in dem durch eine Vakuumpumpeinrichtung 18 ein Vakuum von unter 1 mbar, insbesondere etwa 0,5 mbar, erzeugbar ist. Innerhalb des Gehäuses 23 sind ein erstes Target 3A und ein zweites Target 3B angeordnet. Zwischen diesen zwei Targets 3A, 3B ist eine stabförmige Anode 11 angeordnet. Zwischen der Anode 11 und dem ersten Target 3A liegt eine erste Spannung V1. Zwischen der Anode 11 und dem zweiten Target 3B liegt eine zweite Spannung V2. Das erste Target 3A und das zweite Target 3B sind gemeinsam von einem Kathodengehäuse 25 mit einer Gaseinlaßöffnung 14 umgeben, die mit einer nicht dargestellten Gasversorgung verbunden ist, über die ein Inertgas 19, insbesondere Argon, in das Gehäuse einleitbar ist. Das Kathodengehäuse 25 dient der Führung des Inertgasstroms und der Abschirmung von Kathodenpotential führenden Oberflächen, die nicht zerstäubt werden sollen. Der Gaseinlaßöffnung 14 liegt eine Gasauslaßöffnung 13 gegenüber, aus der das Inertgas 19 herausströmt. Geodätisch oberhalb der Gasauslaßöffnung 13 ist ein Bauteil 1, eine Gasturbinenschaufel, in einer Halteeinrichtung 30 gehalten. Die Halteeinrichtung 30 ist über eine Zusatzspannungsversorgung 22 mit der Anode 11 elektrisch verbindbar. Eine zwischen die Anode 11 und die Halteeinrichtung 30 respektive das Bauteil 1 anlegbare Gleichspannung bewirkt eine Oberflächenreinigung des Bauteils 1 durch ionisierte Inertgasatome. Die Halteeinrichtung 30 hat vorzugsweise eine nicht näher dargestellte Antriebsvorrichtung, wodurch eine kontinuierliche Drehung des Bauteils 1 um seine Längsachse 1A stattfindet. Geodätisch oberhalb des Bauteils 1 ist eine Beheizungseinrichtung 9 zur Beheizung des Bauteils 1 über Wärmestrahlung und/oder Konvektion angeordnet. Die Beheizungseinrichtung 9 kann selbstverständlich je nach Anforderung auch auf gleichem geodätischem Niveau neben dem Bauteil 1 angeordnet sein. Ebenfalls können alle Konfigurationsangaben in umgekehrter geodätischer oder in horizontaler Anordnung ausgeführt werden.

Das erste Target 3A besteht aus Molybdän 4 und das zweite Target 3B aus Silizium 5. Indem die Spannungen V1, V2 angelegt werden, wird Argon 19 zu Argon-Ionen 19A ionisiert und auf die Targets 3A, 3B beschleunigt. Dabei sind die den Argon-Ionen 19A ausgesetzten Flächen 4A und 5A des ersten Targets 3A bzw. des zweiten Targets 3B sowie die Spannungen V1 und V2 so gewählt, daß Molybdän 4 und Silizium 5 genau im gewünschten Mengenverhältnis aus dem ersten Target 3A bzw., dem zweiten Target 3B herausgeschlagen werden. Die herausgeschlagenen Molybdän- und Silizium-Atome werden durch die Auslaßöffnung 13 vom Inertgas 19 zum Substrat 6 transportiert, welches auf der Oberfläche der Gasturbinenschaufel 7 angeordnet ist. Auf diese Weise kann die gewünschte Molybdänsilicidschicht, vorzugsweise MoSi₂/Si, mit einer hohen Beschichtungsrate hergestellt werden. Die Beschichtungsrate beträgt vorzugsweise zwischen 30 und 80 µm pro Stunde.

Fig. 2 zeigt einen Ausschnitt eines Längsschnittes durch eine Gasturbinenschaufel 7 mit einer Beschichtung 16. Die Beschichtung 16 umfaßt eine auf die Oberfläche der Gasturbinenschaufel 7 aufgebrachte Oxidations- und/oder Korrosionsschutzschicht 10, vorzugsweise eine MCrAlY-Legierung, wobei M für Eisen, Kobalt oder Nickel steht, Cr Chrom, Al Aluminium ist und Y für Yttrium oder ein Metall der Seltenen Erden steht. Auf die Schutzschicht 10 ist eine keramische Wärmedämmschicht 8, vorzugsweise auf Zirkonoxid-Basis aufgebracht. Die Wärmedämmschicht 8 bildet das Substrat 6. Auf die Wärmedämmschicht 8 ist als Erosionsschutz eine Schicht 1 mit Molybdänsilicid mittels des in Fig. 1 beschriebenen Gasstrahl-PVD-Verfahrens aufgebracht.

## Patentansprüche

1. Verfahren zur industriellen Herstellung einer Schicht (1) mit MoSi₂ auf einem Substrat (6) mittels eines Gasstrahl-PVD-Verfahrens, bei dem Ionen (2) eines Sputtergases in Richtung auf mindestens ein Target (3) beschleunigt werden, welche Ionen Molybdän (4) und Silicium (5) aus dem mindestens einen Target (3) herausschlagen und zum Substrat (6) transportieren, wobei sich das herausgeschlagene Molybdän (4) und Silizium (5) auf das Substrat (6) absetzen.

2. Verfahren nach Anspruch 1,
bei dem eine Beschichtungsrate zwischen 10 und 100 um pro Stunde, insbesondere zwischen 30 und 80 µm pro Stunde, eingestellt wird.

3. Verfahren nach Anspruch 1 oder 2,
bei dem das Substrat (6) auf einer Gasturbinenschaufel (7) aufgebracht und insbesondere eine keramische Wärmedämmschicht (8) ist.

4. Verfahren nach einem der vorhergehenden Ansprüche,
bei dem die Schicht (1) aus MoSi₂ und Silizium aufgebaut wird.

5. Verfahren nach einem der vorhergehenden Ansprüche, bei dem die Schicht (1) unter Anwesenheit von Sauerstoff gebildet wird.

6. Verfahren nach einem der vorhergehenden Ansprüche, bei dem ein erstes Target (3A) aus Molybdän (4) und ein zweites Target (3B) aus Silizium (5) verwendet werden, wobei die Ionen zum ersten und zum zweiten Target (3A, 3B) unter einer jeweils anderen, den unterschiedlichen spezifischen Widerständen von Molybdän (4) und Silizium (5) angepaßten Spannungen (V1, V2) beschleunigt werden.

7. Verfahren nach Anspruch 5, bei dem das erste und das zweite Target (3A, 3B) einander gegenüberliegend angeordnet werden.

8. Verfahren nach einem der Ansprüche 1 bis 4,
bei dem das mindestens eine Target (3) aus, insbesondere vorgesintertem, MoSi₂/Si besteht, wobei ein spezifischer Widerstand kleiner als 700 Ωm eingestellt wird.

9. Verfahren nach einem der vorhergehenden Ansprüche,
bei dem die Ionen aus einem Gleichstrom-Glimmentladungsplasma beschleunigt werden.

## Claims

1. Process for the industrial production of a layer (1) comprising MoSi₂ on a substrate (6) using a gas-stream/PVD process, in which ions (2) from a sputtering gas are accelerated in the direction of at least one target (3) and eject ions of molybdenum (4) and silicon (5) from the at least one target (3) and transport them to the substrate (6), the ejected molybdenum (4) and silicon (5) being deposited on the substrate (6).

2. Process according to Claim 1, in which a coating rate of between 10 and 100 µm per hour, in particular between 30 and 80 µm per hour, is set.

3. Process according to Claim 1 or 2, in which the substrate (6) is applied to a gas turbine blade (7) and, in particular is a ceramic thermal insulation layer (8).

4. Process according to one of the preceding claims, in which the layer (1) is made of MoSi₂ and silicon.

5. Process according to one of the preceding claims, in which the layer (1) is formed in the presence of oxygen.

6. Process according to one of the preceding claims, in which a first target (3A) made of molybdenum (4) and a second target (3B) made of silicon (5) are used, the ions being accelerated towards the first and second targets (3A, 3B) using different respective voltages (V1, V2) matched to the different resistivities of molybdenum (4) and silicon (5).

7. Process according to Claim 5, in which the first and second targets (3A, 3B) are arranged opposite one another.

8. Process according to one of Claims 1 to 4, in which the at least one target (3) consists of MoSi₂/Si, in particular presintered MoSi₂/Si, a resistivity of less than 700 Ωm being set.

9. Process according to one of the preceding claims, in which the ions are accelerated from a DC glow discharge plasma.

## Revendications

1. Procédé de production industrielle d'une couche (1) ayant du MoSi₂ sur un substrat (6) au moyen d'un procédé de dépôt physique en phase vapeur à jet de gaz, dans lequel des ions d'un gaz de pulvérisation cathodique sont accélérés en direction d'au moins une cible (3), lesquels ions éjectent du molybdène (4) et du silicium (5) de la au moins une cible (3) et les transportent au substrat (6), le molybdène (4) et le silicium (5) éjectés se déposant sur le substrat (6).

2. Procédé suivant la revendication 1, dans lequel on établit une vitesse de revêtement comprise entre 10 et 100 µm à l'heure, notamment comprise entre 30 et 80 µm à l'heure.

3. Procédé suivant la revendication 1 ou 2, dans lequel le substrat (6) est déposé sur une aube (7) de turbine à gaz et est notamment une couche (8) calorifuge en céramique.

4. Procédé suivant l'une des revendications précédentes, dans lequel la couche (1) est constituée de MoSi₂ et de silicium.

5. Procédé suivant l'une des revendications précédentes, dans lequel la couche (1) est formée en présence d'oxygène.

6. Procédé suivant l'une des revendications précédentes, dans lequel on utilise une première cible (3A) en molybdène (4) et une deuxième cible (3B) en silicium (5), les ions étant accélérés vers la première et la deuxième cible (3A, 3B) sous des tensions (V1, V2) respectivement autres, adaptées aux résistances spécifiques différentes du molybdène (4) et du silicium (5).

7. Procédé suivant la revendication 5, dans lequel la première et la deuxième cible (3A, 3B) sont disposées de manière mutuellement opposée.

8. Procédé suivant l'une des revendications 1 à 4, dans lequel la au moins une cible (3) est en MoSi₂/Si, notamment préfrittée, en le réglant à une résistance spécifique inférieure à 700 Ωm.

9. Procédé suivant l'une des revendications précédentes, dans lequel on accélère les ions d'un plasma de décharge à effet corona en courant continu.
